# EUROPEAN PATENT APPLICATION

(11) **EP 2 623 217 A2**
(43) Date of publication of application: **07.08.2013**
(21) Application number: 13153627.8
(22) Date of filing: 01.02.2013
(51) Int. Cl.: B06B 1/06

(54) **Ultrasonic Probe and Manufacturing Method Thereof**

(30) Priority: 03.02.2012 KR 20120011062
(71) Applicant: Samsung Medison Co., Ltd., Gangwon-do 250-870 (KR)
(72) Inventor: Kim, Mi Ri, Seoul (KR); Park, Jung Lim, Gyeonggi-do (KR)
(74) Representative: Schmid, Wolfgang

(57) **Abstract**

An ultrasonic probe is provided and includes a matching layer (10) providing conductivity by forming an electrode in the matching layer. A method of manufacturing the ultrasonic probe is also described. The ultrasonic probe includes a piezoelectric material (20) and at least one matching layer (10) disposed on the front surface of the piezoelectric material and includes an electrode (13, 15, 41).

## Description

### TECHNICAL FIELD

The present application relates to an ultrasonic probe to generate an image of an internal state of an object using ultrasound.

### BACKGROUND

An ultrasonic diagnosis apparatus irradiates an ultrasonic signal toward a target region of the interior of a body of an object from the surface of the body of the object, and non-invasively acquires an image regarding a soft tissue tomogram or a blood stream using information of a reflected ultrasonic signal (e.g., an ultrasonic echo signal).

The ultrasonic diagnosis apparatus is small and inexpensive, executes display in real time and has high safety without radiation exposure, as compared to other image diagnosis apparatuses, such as an X-ray diagnosis apparatus, an X-ray computerized tomography (CT) scanner, a magnetic resonance image (MRI), and a nuclear medicine diagnosis apparatus, and is thus widely used for heart diagnosis, celiac diagnosis, urinary diagnosis, and obstetrical diagnosis.

The ultrasonic diagnosis apparatus includes an ultrasonic probe for transmitting an ultrasonic signal to an object and receiving an ultrasonic echo signal reflected by the object to acquire an ultrasonic image of the object.

The ultrasonic probe includes a piezoelectric layer in which a piezoelectric material vibrates to execute a conversion between an electrical signal and an acoustic signal. A matching layer reduces an acoustic impedance difference between the piezoelectric layer and the object so as to maximally transmit ultrasonic waves generated from the piezoelectric layer to the object. A lens concentrates ultrasonic waves proceeding in the forward direction of the piezoelectric layer on a predetermined point. A backing layer prevents ultrasonic waves from proceeding in the backward direction of the piezoelectric layer to prevent image distortion.

### SUMMARY

Therefore, it is an aspect of the present application to provide an ultrasonic probe including a matching layer providing conductivity by forming an electrode in the matching layer and a method of manufacturing the same.

Additional aspects of the application will be set forth in part in the description which follows and, in part, will be obvious from the description, or may be learned by practice of the subject matter described herein.

In accordance with one aspect of the present application, an ultrasonic probe includes a piezoelectric material and a matching layer disposed on the front surface of the piezoelectric material, wherein electrodes are formed in the matching layer. External electrodes may be formed on the front and rear surfaces of the matching layer.

The internal electrodes of the matching layer may be formed to electrically connect the external electrodes.

The internal electrodes of the matching layer may be formed to be perpendicular to the external electrodes.

The internal electrodes may be formed in a one-dimensional or two-dimensional array.

The piezoelectric material and the matching layer may be processed into a one-dimensional or two-dimensional array, and an interval between internal electrodes of the matching layer may be smaller than a pitch of an element constituting an array of the piezoelectric material.

The matching layer may include at least one layer.

In accordance with another aspect of the present application, a method of manufacturing an ultrasonic probe includes forming electrodes in a matching layer and installing the matching layer provided with the electrodes on one surface of a piezoelectric material.

The forming of the electrodes in the matching layer may include the steps of forming a plurality of kerfs at one surface of the matching layer; forming an electrode on the surface of the matching layer, at which the kerfs are formed; filling the kerfs; and cutting the front and rear surfaces of the matching layer to expose the electrodes. The step of forming of the kerfs at one surface of the matching layer may include forming a plurality of kerfs at one surface of the matching layer in a one-dimensional or two-dimensional array.

The kerfs may have a width smaller than a pitch of an element of the piezoelectric material.

The step of forming of an electrode on the surface of the matching layer, at which the kerfs are formed, may include forming an electrode on at least inner side surfaces of the kerfs.

The step of filling the kerfs may include filling the kerfs with a material used to form the matching layer.

The step of cutting of the front and rear surfaces of the matching layer to expose the electrodes may include cutting the front and rear surfaces of the matching layer in the transverse direction to expose the electrodes formed on inner side surfaces of the kerfs through the front and rear surfaces of the matching layer.

The method may further include the step of forming external electrodes on the front and rear surfaces of the matching layer through which the electrodes are exposed, after cutting of the front and rear surfaces of the matching layer to expose the electrodes.

The step of installing of the matching layer provided with the electrodes on one surface of a piezoelectric material may include installing the matching layer on one surface of the piezoelectric material such that the electrodes formed on the matching layer are electrically connected to the piezoelectric material.

The method may further include the step of processing the matching layer and the piezoelectric material in a one-dimensional or two-dimensional array and installing a protective layer on the front surface of the matching layer, after installing of the matching layer on one surface of the piezoelectric material.

The matching layer may include internal electrodes formed in a two-dimensional array, and processing the matching layer and the piezoelectric material in a two-dimensional array may be performed by dividing the matching layer and the piezoelectric material in diagonal directions of lattices formed by the internal electrodes processed in the two-dimensional array.

The protective layer may be grounded, or an electrical signal may be applied to the protective layer.

The protective layer may include a radio frequency (RF) shield or a Clear Shield (CS) plastic film.

Additional advantages and novel features will be set forth in part in the description which follows, and in part will become apparent to those skilled in the art upon examination of the following and the accompanying drawings or may be learned by production or operation of the examples. The advantages of the present teachings may be realized and attained by practice or use of various aspects of the methodologies, instrumentalities and combinations set forth in the detailed examples discussed below.

### BRIEF DESCRIPTION OF THE DRAWINGS

These and/or other aspects of the application will become apparent and more readily appreciated from the following description of the examples, taken in conjunction with the accompanying drawings of which:
FIG. 1 is a diagram for describing a process of manufacturing a matching layer according to an example of the present application;
FIGS. 2 and 3 are perspective views illustrating that electrodes are formed on a matching layer at which kerfs are formed;
FIGS. 4 and 5 are perspective views illustrating that electrodes are formed in a matching layer;
FIGS. 6 and 7 are perspective views illustrating that electrodes are formed in the matching layer and on the front and rear surfaces of the matching layer;
FIG. 8 is a diagram for describing a process of manufacturing an ultrasonic probe including the matching layer of FIG. 1;
FIG. 9 is a magnified view of a portion of FIG. 8;
FIG. 10 is perspective view illustrating an element of the matching layer of FIG. 9;
FIGS. 11A and 11B are diagrams illustrating the step of dicing of a matching layer according to an example of the present application; and
FIG. 12 is a flowchart illustrating a method of manufacturing an ultrasonic probe according to an example of the present application.

### DETAILED DESCRIPTION

In the following detailed description, numerous specific details are set forth by way of examples in order to provide a thorough understanding of the relevant teachings. However, it should be apparent to those skilled in the art that the present teachings may be practiced without such details. In other instances, well known methods, procedures, components, and/or circuitry have been described at a relatively high-level, without detail, in order to avoid unnecessarily obscuring aspects of the present teachings.

Reference will now be made in detail to the examples of the present application which are illustrated in the accompanying drawings, wherein like reference numerals refer to like elements throughout.

Hereinafter, an ultrasonic probe and a method of manufacturing the same will be described.

An ultrasonic probe according to an example of the present application includes a piezoelectric layer 20. A matching layer 10 is disposed on the front surface of the piezoelectric layer 20. A protective layer 30 is disposed on the front surface of the matching layer 10. A backing layer 40 is disposed on the rear surface of the piezoelectric layer 20.

Effect of voltage generation in a designated material in response to applied mechanical pressure and effect of mechanical deformation in response to applied voltage are respectively referred to as piezoelectric effect and inverse piezoelectric effect, and a material exhibiting such effects is referred to as a piezoelectric material. In other words, the piezoelectric material is a material which converts electrical energy into mechanical vibration energy or converts mechanical vibration energy into electrical energy.

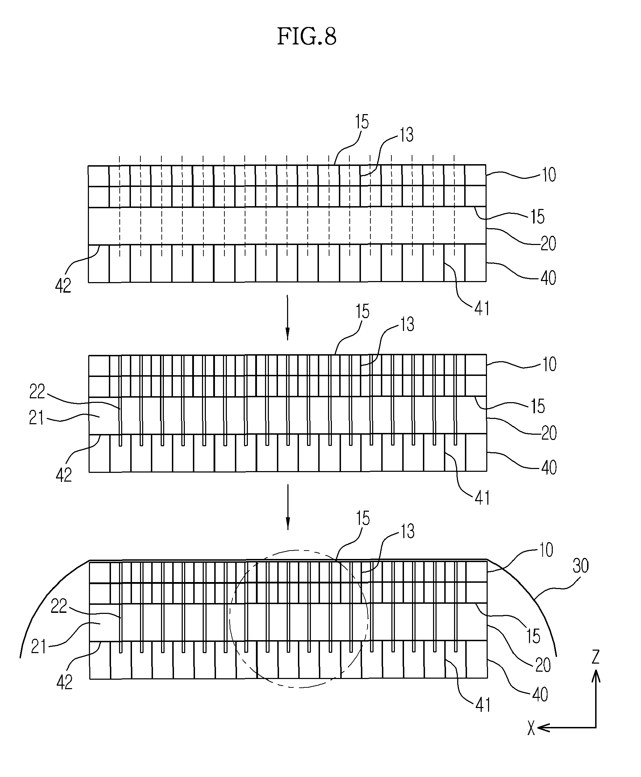

The ultrasonic probe according to the present application includes the piezoelectric layer 20 (FIG. 8) formed of a piezoelectric material that generates ultrasonic waves in response to an electrical signal applied thereto by converting the electrical signal into mechanical vibration.

The piezoelectric material constituting the piezoelectric layer 20 may include PZMT single crystals formed of lead zirconate titanate (PZT) ceramics, a solid solution of lead magnesium niobate, and lead titanate or PZNT single crystals formed of a solid solution of lead zinc niobate and lead titanate.

In addition, the piezoelectric layer 20 may be a single-layered or multi-layered stack structure.

In general, impedance and voltage are easily controlled in the piezoelectric layer 20 having a stack structure, so that excellent sensitivity, high energy conversion rate, and soft spectrum may be obtained.

In addition, electrodes to which electrical signals are applied may be formed over the front and rear surfaces of the piezoelectric layer 20. When the electrodes are formed over the front and rear surfaces of the piezoelectric layer 20, one of the electrodes may be a ground electrode and the other may be a signal electrode.

The matching layer 10 is provided on the front surface of the piezoelectric layer 20. The matching layer 10 reduces an acoustic impedance difference between the piezoelectric layer 20 and an object to match acoustic impedances of the piezoelectric layer 20 and the object. Thus, ultrasonic waves generated in the piezoelectric layer 20 are effectively transmitted to the object.

For this, the matching layer 10 may have a middle value between the acoustic impedances of the piezoelectric layer 20 and the object.

The matching layer 10 may be formed of a glass or resin material. In addition, a plurality of matching layers 10 may be formed, and the matching layers 10 may be formed of different materials in order to change the acoustic impedance stepwise from the piezoelectric layer 20 to the object.

According to the present example, electrodes are formed in the matching layer 10 and over the front and rear surfaces of the matching layer 10, and this will be described later with reference to the drawings.

The piezoelectric layer 20 and the matching layer 10 may be processed in a two-dimensional matrix array by a dicing process or in a one-dimensional array.

The protective layer 30 may be formed on the front surface of the matching layer 10. The protective layer 30 may be an RF shield capable of preventing leakage of a high-frequency component generated in the piezoelectric layer 20 to the outside and blocking inflow of an external high-frequency signal.

Furthermore, the protective layer 30 may be formed by coating a conductive material on a surface of a film having moisture resistance and chemical resistance and may be a CS film capable of protecting internal parts from water and chemicals used in disinfection, and the like.

Although not shown in the drawings, a lens may be formed on the front surface of the protective layer 30. The lens may have a convex shape in an ultrasound-radiating direction so as to concentrate the ultrasonic waves, but the lens may have a concave shape if the speed of sound is less than that in the body of an object (e.g., human body).

The backing layer 40 is formed on the rear surface of the piezoelectric layer 20. The backing layer 40 absorbs ultrasonic waves generated in the piezoelectric layer 20 and proceeding in the backward direction of the piezoelectric layer 20, thereby blocking reflection of ultrasound in the forward direction. Accordingly, with this construction image distortion may be prevented.

The backing layer 40 may be fabricated in a multi-layered structure in order to improve ultrasonic wave attenuation or blocking effects.

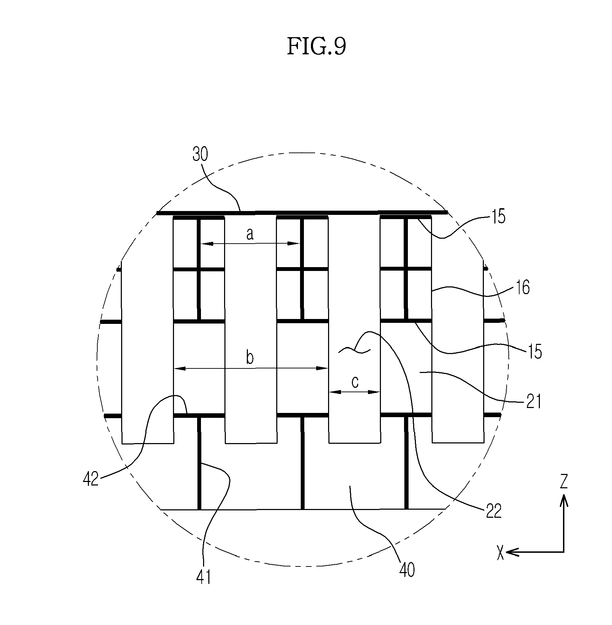

Electrodes 41 and 42, which apply an electrical signal to the piezoelectric layer 20, may be formed on the front surface of the backing layer 40 that contacts the piezoelectric layer 20 and in the backing layer 40. The electrode 41 formed in the backing layer 40 may be fabricated such that the electrode 41 is allocated to each of the elements 21 of the piezoelectric layer 20 to respectively apply electrical signals to the elements 21 while the piezoelectric layer 20 is processed in a two-dimensional or one-dimensional array (FIGS. 8 and 9).

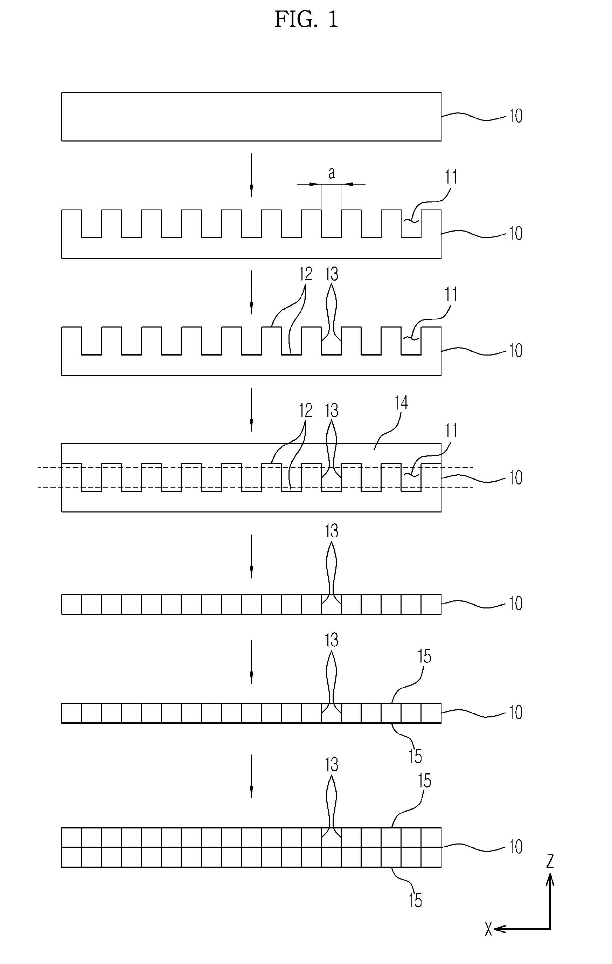

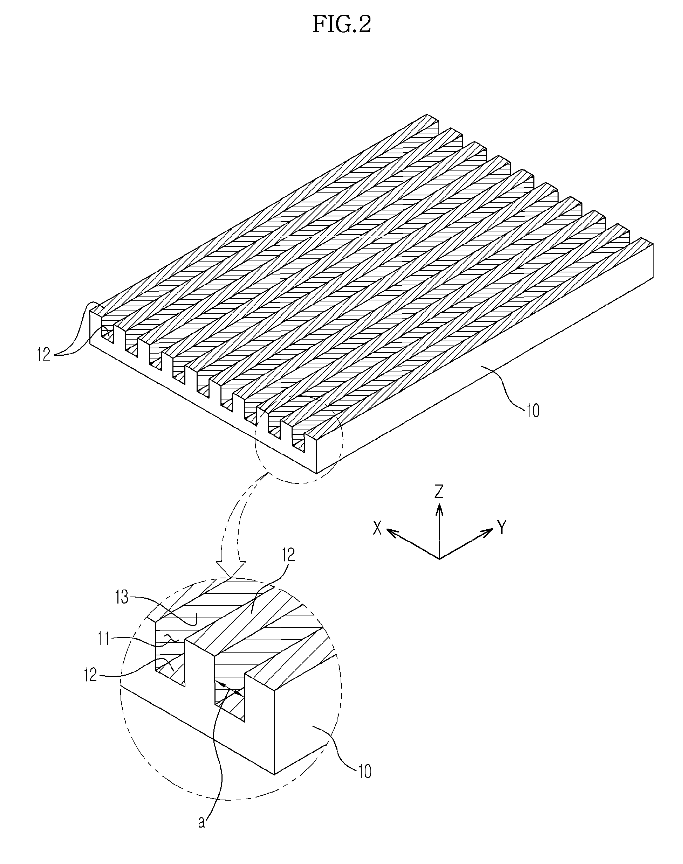

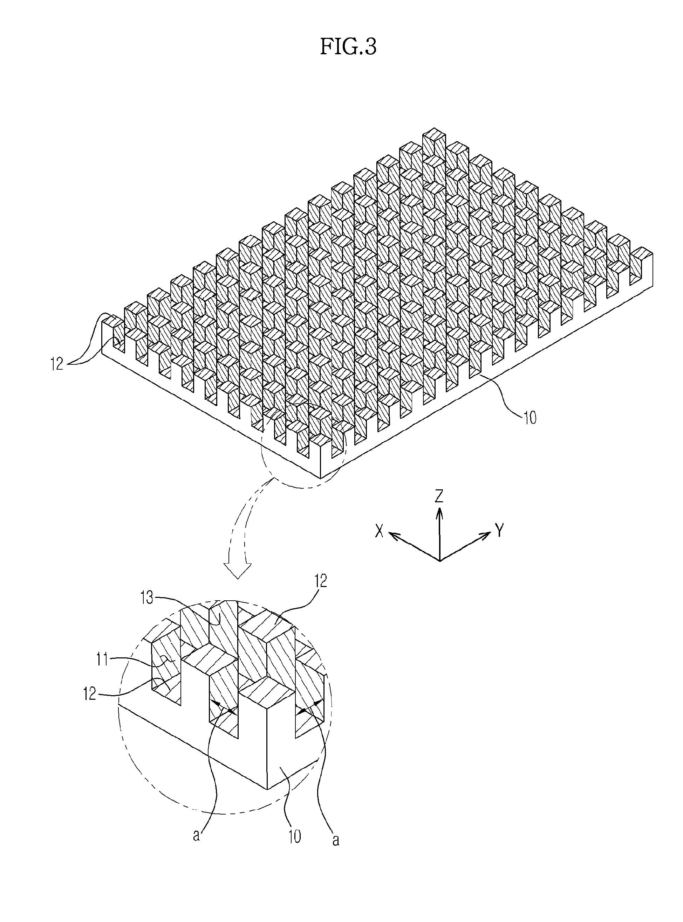

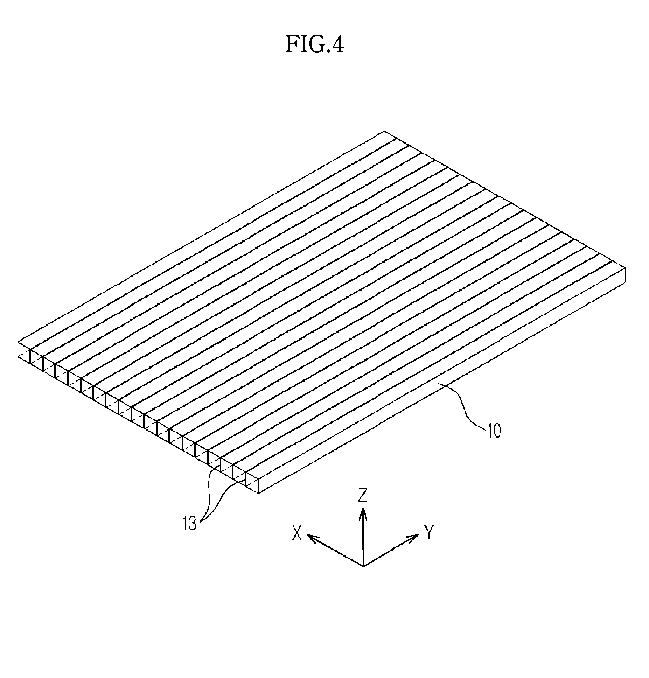

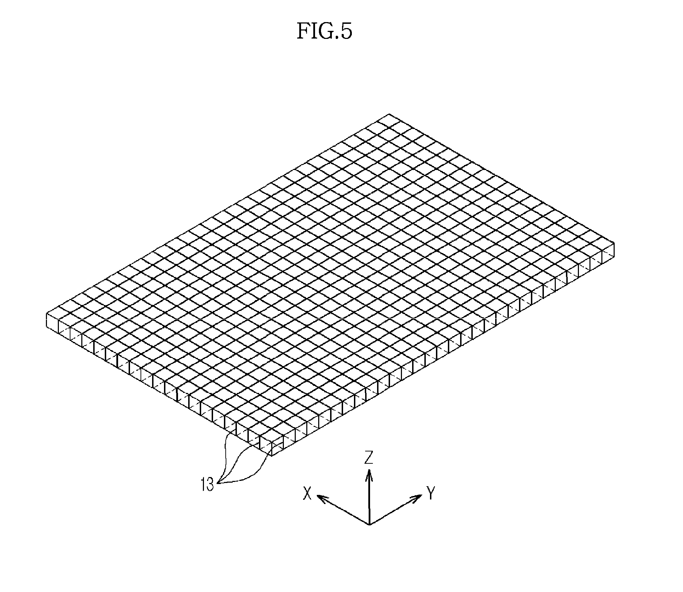

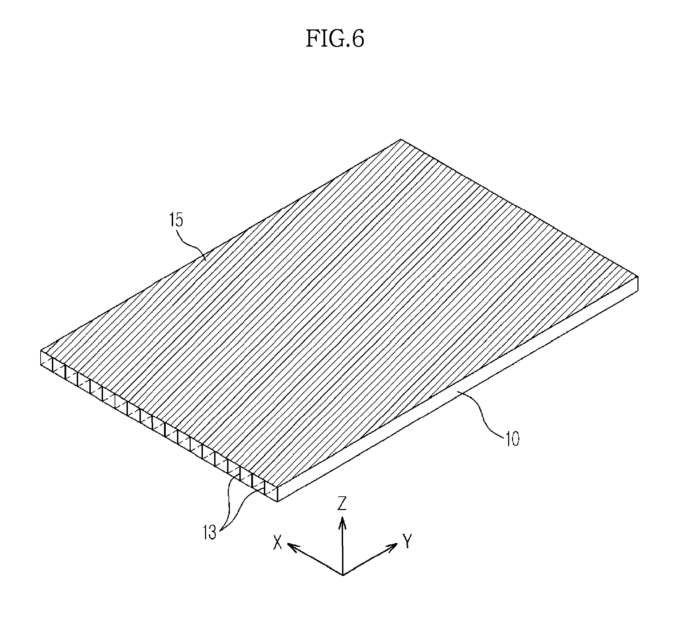

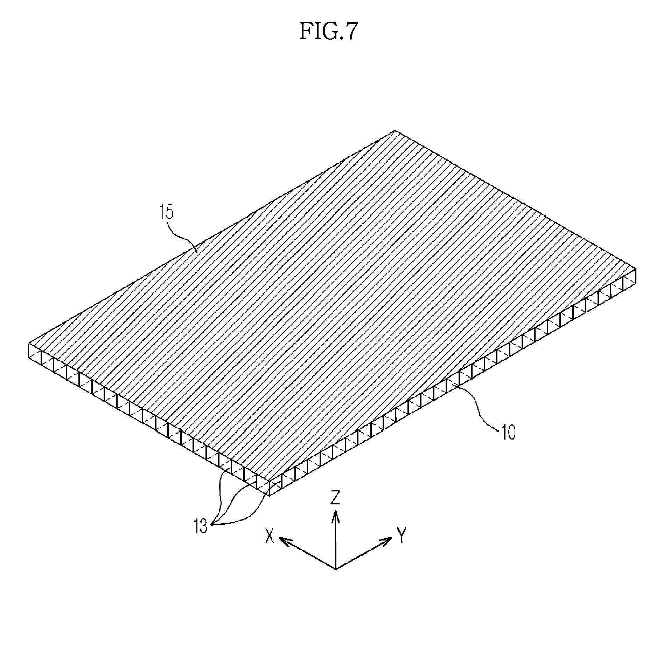

FIG. 1 is a diagram for describing a process of manufacturing a matching layer 10 according to an example of the present application. FIG. 2 is a perspective view illustrating that electrodes 12 and 13 are formed on a matching layer 10 at which kerfs 11 are formed in a one-dimensional array. FIG. 3 is a perspective view illustrating that electrodes 12 and 13 are formed on a matching layer 10, at which kerfs 11 are formed in a two-dimensional array. FIG. 4 is a perspective view illustrating that an electrode 13 is formed in a matching layer 10 in a one-dimensional array. FIG. 5 is a perspective view illustrating that an electrode 13 is formed in a matching layer 10 in a two-dimensional array. FIG. 6 is a perspective view illustrating that an electrode 15 is formed on the front and rear surfaces of the matching layer 10 of FIG. 4. FIG. 7 is a perspective view illustrating that an electrode 15 is formed on the front and rear surfaces of the matching layer 10 of FIG. 5.

As shown in FIG. 1, first, the kerfs 11 are formed at one surface of a material used to form the matching layer 10. The kerfs 11 may be processed in a one-dimensional array as shown in FIG. 2, or in a two-dimensional array as shown in FIG. 3. In certain examples, the kerfs 11 may be formed by a dicing process. The kerfs 11 may be formed such that a width a thereof is smaller than a pitch b of an element 21 of the piezoelectric layer 20.

The pitch b is defined as shown in FIG. 9. The width a of the kerfs 11 may be greater than a width c of a kerf 22 between elements 21 formed by processing the piezoelectric layer 20 in a two-dimensional or one-dimensional array.

After formation of the kerfs 11 at one surface of the material used to form the matching layer 10, electrodes 12 and 13 are formed on the surface of the matching layer 10, at which the kerfs 11 are formed.

The electrodes 12 and 13 may be formed by coating or depositing a conductive material on the surface of the matching layer 10, at which the kerfs 11 are formed.

Referring to FIGS. 2 and 3, the electrodes 12 and 13 include the electrode 13 formed on inner side surfaces of the kerfs 11 and the electrode 12 formed on the bottom surfaces of the kerfs 11 and on surfaces relatively protruding due to the formation of the kerfs 11. Also, the electrode 13 may be formed only on the inner side surfaces of the kerfs 11.

After formation of the electrodes 12 and 13, the kerfs 11 are filled with the material used to form the matching layer 10.

The process may be finished after filling of the kerfs 11 with the material 14 used to form the matching layer 10, or after filling of the electrodes 12 and 13 as shown in the fourth structure of FIG. 1.

Particularly, if the electrode 13 is formed only on the inner side surfaces of the kerfs 11, the process may be finished after filling of the kerfs 11 in order to reduce waste or loss during the process.

After filling of the kerfs 11, the front and rear surfaces of the matching layer 10 are cut in the transverse direction.

In this regard, the transverse direction refers to a direction parallel to the xy plane. The front and rear surfaces of the matching layer 10 are cut along dashed lines shown in the fourth structure of FIG. 1, such that the electrode 13 formed on the inner side surfaces of the kerfs 11, is exposed through the front and rear surfaces of the matching layer 10. Hereinafter, the electrode 13 formed on the inner side surfaces of the kerfs 11 is referred to as internal electrode 13.

FIGS. 4 and 5 illustrate that a plurality of internal electrodes 13 are exposed through the front and rear surfaces of the matching layer 10 after cutting of the front and rear surfaces 10 of the matching layer 10. Any known cutting methods and other methods such as grinding may be used for the cutting.

After exposing the internal electrode 13 of the matching layer 10 through the front and rear surfaces thereof, an external electrode 15 is formed on the front and rear surfaces of the matching layer 10. The external electrode 15 may be formed by coating or depositing a conductive material on the front and rear surfaces of the matching layer 10. FIGS. 6 and 7 illustrate that the external electrode 15 is formed on the front and rear surfaces of the matching layer 10.

The matching layer 10 may be a single-layered matching layer 10 prepared as described above or a multi-layered matching layer 10 having at least two stacked single layers. Hereinafter, a double-layered matching layer will be described as an example of the multi-layered matching layer 10.

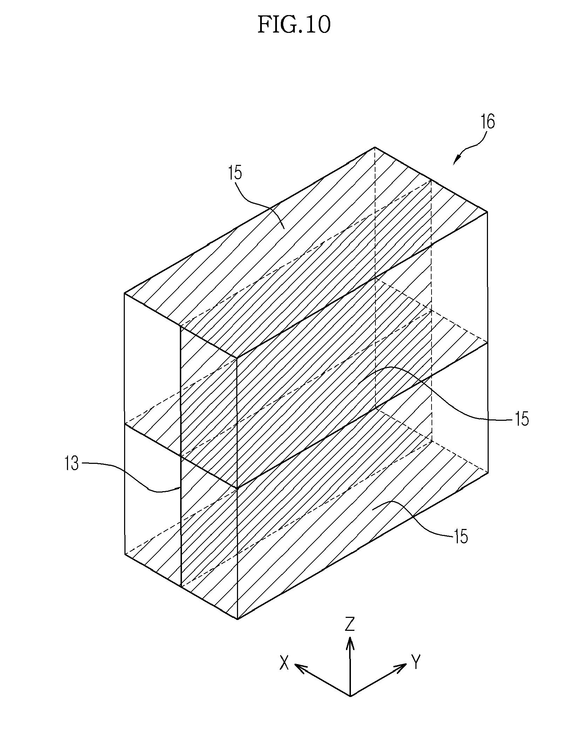

FIG. 8 is a diagram for describing a process of manufacturing an ultrasonic probe including a matching layer 10 provided with an internal electrode 13 and an external electrode 15 as described above. FIG. 9 is a magnified view of a portion of FIG. 8. FIG. 10 is perspective view illustrating an element 16 of the matching layer 10 of FIG. 9.

The matching layer 10 provided with the internal electrode 13 and the external electrode15 as described above is installed on the front surface of the piezoelectric layer 20, and the backing layer 40 is installed on the rear surface of the piezoelectric layer 20.

Electrodes may be formed on the front and rear surfaces of the piezoelectric layer 20. Also, an electrode 42 may be formed on the front surface of the backing layer 40. Furthermore, an electrode 41, which penetrates the backing layer 40 extending to the rear surface of the backing layer 40, may be formed in the backing layer 40, as shown in FIGS. 8 and 9.

An electrical signal may be applied to the piezoelectric layer 20 via the electrode 41 formed in the backing layer 40. The internal electrode 41 of the backing layer 40 may be formed at the same interval as the electrode 13 formed in the matching layer 10.

In order to form the piezoelectric layer 20 in a one-dimensional or two-dimensional array, a stack structure of the matching layer 10, the piezoelectric layer 20, and the backing layer 40 is processed as shown in the second structure of FIG. 8. The piezoelectric layer 20 may be processed in a one-dimensional or two-dimensional array by a dicing process.

As shown in the first structure of FIG. 8, the piezoelectric layer 20 is divided by forming kerfs 22 between two adjacent internal electrodes 13 of the matching layer 10 along the dashed lines. Accordingly, the internal electrode 13 of the matching layer 10 may be allocated to each of the elements 21 of the divided piezoelectric layer 20.

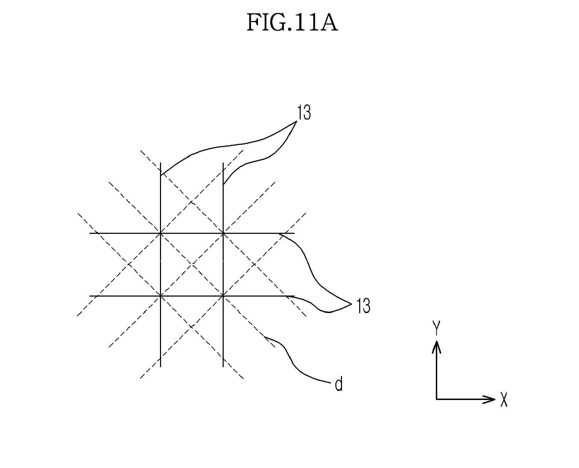

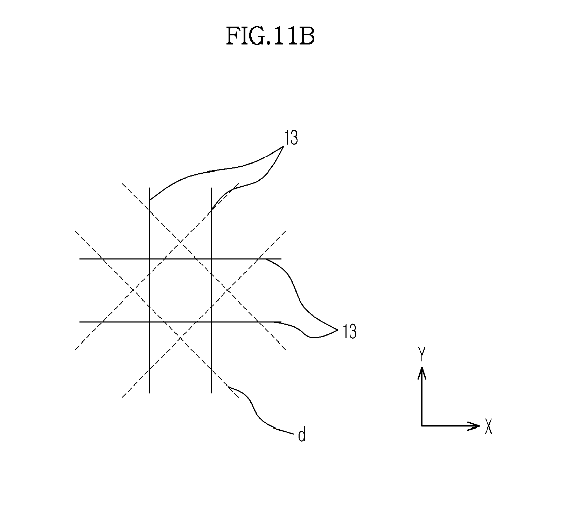

The piezoelectric layer 20 may be divided into a two-dimensional array as shown in FIGS. 11A and 11B. If the internal electrode 13 of the matching layer 10 is formed in a two-dimensional array as shown in FIG. 7, the piezoelectric layer 20 may be divided into a two-dimensional array by dicing in diagonal directions of lattices formed by the internal electrode 13. That is, the matching layer 10 and the piezoelectric layer 20 may be divided into a two-dimensional array through a dicing process along the dashed lines d shown in the FIGS. 11A and 11B. This is one example of various methods of dividing into a two-dimensional array, and various other techniques can be used.

After processing of the piezoelectric layer 20 into an array, a protective layer 30 is formed on the front surface of the matching layer 10. The protective layer 30 may be an RF shield or a CS film as described above.

In the ultrasonic probe according to the present example, an electrical signal may be applied to the piezoelectric layer 20 via the protective layer 30 disposed on the front surface of the matching layer 10 and the electrodes 41 and 42 formed at the backing layer 40.

For example, as shown in FIG. 9, by using the protective layer 30 as a ground electrode and the electrodes 41 and 42 of the backing layer 40 as signal electrodes, the front surface of the piezoelectric layer 20 is grounded via the internal and external electrodes 13 and 15 of the matching layer 10, electrically connected to the protective layer 30, and an electrical signal is applied to the rear surface of the piezoelectric layer 20 via the electrodes 41 and 42 of the backing layer 40. As a result, a voltage is applied to the front and rear surfaces of the piezoelectric layer 20. The direction in which the electrical signal is applied may also be inverted. In addition to the structure shown in the exemplary drawings, various modifications may be made in the signal electrode.

One of the electrodes used to apply the electrical signal to the piezoelectric layer 20 may not be formed by providing conductivity to a non-conductive matching layer 10 by forming the electrode 13 in the matching layer 10, and using the protective layer 30 as one of the electrodes to which the electrical signal is applied. If the protective layer 30 is used as a ground electrode, a separate ground electrode for grounding of one surface of the piezoelectric layer 20 may not be required.

FIG. 10 illustrates an element 16 of the divided matching layer 10. The external electrode 15 is disposed on the front and rear surfaces of the matching layer 10. Thus, the external electrode 15 disposed on the front surface is electrically connected to the protective layer 30, and the external electrode 15 disposed on the rear surface is electrically connected to the piezoelectric layer 20. In addition, the internal electrode 13 electrically connects the external electrodes 15 disposed on the front and rear surfaces of the matching layer 10. Although a single-layered matching layer 10 may execute the same function, a multi-layered matching layer 10 may be used to match acoustic impedance.

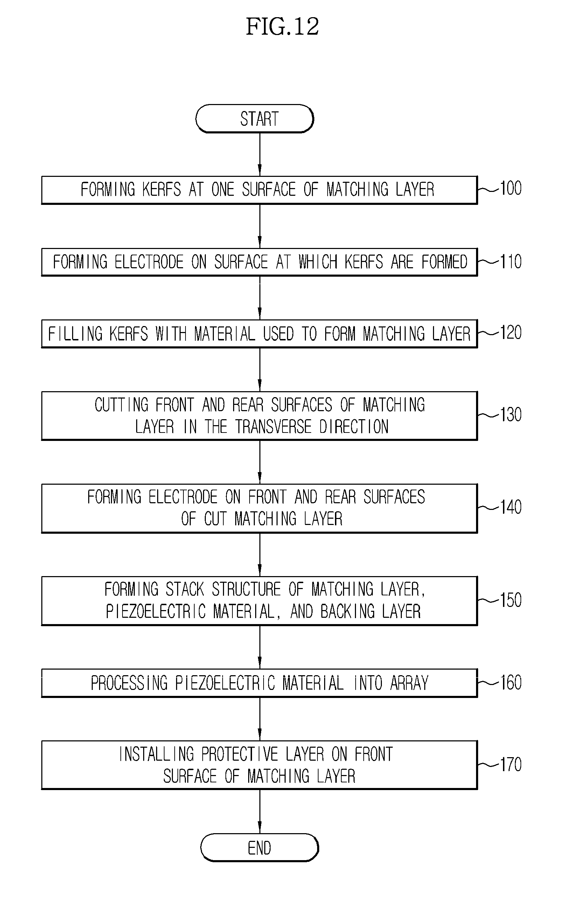

FIG. 12 is a flowchart illustrating a method of manufacturing an ultrasonic probe according to an example of the present application.

Referring to FIG. 12, kerfs 11 are formed at one surface of the matching layer 10 (Operation 100).

The kerfs 11 may be processed into a one-dimensional array as shown in FIG. 2 and into a two-dimensional array as shown in FIG. 3. The kerfs 11 may be formed by a dicing process. The kerfs 11 may be formed such that a width a thereof is smaller than a pitch b of an element 21 of the piezoelectric layer 20 (FIG. 9).

The width a of the kerf 11 may be greater than an interval between elements 21 constituting an array of the piezoelectric layer 20, i.e., a width c of a kerf 22.

After formation of the kerfs 11 at one surface of the matching layer 10, electrodes 12 and 13 are formed on the surface of the matching layer 10, at which the kerfs 11 are formed (Operation 110).

The electrodes 12 and 13 may be formed by coating or depositing a conductive material on the surface at which the kerfs 11 are formed. Referring to FIG. 2, the electrodes 12 and 13 include the electrode 13 formed on inner side surfaces of the kerfs 11 and the electrode 12 disposed on the bottom surfaces of the kerfs 11 and on surfaces relatively protruding due to the formation of the kerfs 11. Also, the electrode 13 may be disposed only on the inner side surfaces of the kerfs 11.

After formation of the electrodes 12 and 13 on one surface of the matching layer 10, at which the kerfs 11 are formed, the kerfs 11 are filled with a material 14 used to form the matching layer 10 (Operation 120).

The process may be finished after filling of the kerfs 11 with the material used to form the matching layer 10 or after filling of the electrodes 12 and 13 as shown in the fourth structure of FIG. 1. If the electrode 13 is formed only on the inner side surfaces of the kerfs 11, the process may be finished after filling of the kerfs 11 in order to reduce waste or loss during the process.

After filling of the kerfs 11, the front and rear surfaces of the matching layer 10 are cut in the transverse direction (Operation 130).

In this regard, the transverse direction refers to a direction parallel to the xy plane. The front and rear surfaces of the matching layer 10 are cut such that the electrode 13 formed on the inner side surfaces of the kerfs 11, i.e., the internal electrode 13, is exposed through the front and rear surfaces of the matching layer 10. Any known cutting methods, or other methods such as grinding, may be used for the cutting step. FIG. 3 illustrates that the internal electrode 13 is exposed through the front and rear surfaces of the matching layer 10 by cutting the front and rear surfaces of the matching layer 10.

After cutting of the front and rear surfaces of the matching layer 10 to expose the internal electrode 13 of the matching layer 10 through the front and rear surfaces of the matching layer 10, an external electrode 15 is formed on the cut front and rear surfaces of the matching layer 10 (Operation 140).

The external electrode 15 may be formed by coating or depositing a conductive material on the front and rear surfaces of the matching layer 10. FIGS. 6 and 7 illustrate that the external electrode 15 is formed on the front and rear surfaces of the matching layer 10.

After formation of the internal and external electrodes 13 and 15 in and on the matching layer 10 as described above, the matching layer 10 is installed on the front surface of the piezoelectric layer 20, and the piezoelectric layer 20 is installed on the front surface of the backing layer 40 to form a stack structure (Operation 150). Electrodes may be formed on the front and rear surfaces of the piezoelectric layer 20. An electrode 42 may also be formed on the front surface of the backing layer 40. In addition, an electrode 41 that penetrates the backing layer 40 and extending to the rear surface of the backing layer 40 may be formed in the backing layer 40 as shown in FIG. 8.

An electrical signal may be applied to the piezoelectric layer 20 via the electrode 41 formed in the backing layer 40. The internal electrode 41 of the backing layer 40 may be formed at the same interval as the internal electrode 13 formed in the matching layer 10.

After formation of the stack structure, the piezoelectric layer 20 is processed into a one-dimensional or two-dimensional array (Operation 160).

In order to form the piezoelectric layer 20 in a one-dimensional or two-dimensional array, the stack structure of the matching layer 10, the piezoelectric layer 20, and the backing layer 40 are processed as shown in the second structure of FIG. 8. The piezoelectric layer 20 may be processed into a one-dimensional or two-dimensional array by a dicing process.

As shown in the first structure of FIG. 8, the piezoelectric layer 20 is divided by forming kerfs 22 between two adjacent internal electrodes 13 of the matching layer 10 along dashed lines. Accordingly, the internal electrode 13 of the matching layer 10 may be allocated to each of the elements 21 of the divided piezoelectric layer 20. In the step of dividing of the piezoelectric layer 20 into a two-dimensional array, if the internal electrode 13 of the matching layer 10 is formed in a two-dimensional array as shown in FIG. 7, the piezoelectric layer 20 may be divided into a two-dimensional array by dicing in diagonal directions of lattices formed by the internal electrode 13. (FIGS. 11A and 11B).

After processing of the piezoelectric layer 20 into an array, the protective layer 30 is installed on the front surface of the matching layer 10 (Operation 170).

The protective layer 30 may be an RF shield or a CS film as described above. In the ultrasonic probe according to the present example, an electrical signal may be applied to the piezoelectric layer 20 via the protective layer 30 formed on the front surface of the matching layer 10 and the electrodes 41 and 42 formed at the backing layer 40.

For example, as shown in FIG. 9, by using the protective layer 30 as a ground electrode and the electrodes 41 and 42 of the backing layer 40 as signal electrodes, the front surface of the piezoelectric layer 20 is grounded via the internal and external electrodes 13 and 15 of the matching layer 10 electrically connected to the protective layer 30.An electrical signal is applied to the rear surface of the piezoelectric layer 20 via the electrodes 41 and 42 of the backing layer 40. As a result, a voltage is applied to the front and rear surfaces of the piezoelectric layer 20. The direction in which the electrical signal is applied may also be inverted.

One of the electrodes used to apply the electrical signal to the piezoelectric layer 20 may not be formed by providing conductivity to a non-conductive matching layer 10 by forming the electrode 13 in the matching layer 10, and using the protective layer 30 as one of the electrodes to which the electrical signal is applied. If the protective layer 30 is used as a ground electrode, a separate ground electrode for grounding one surface of the piezoelectric layer 20 may not be necessary.

As is apparent from the above description, an electrical signal may be applied through the matching layer by forming an electrode in the matching layer. Accordingly, electrical signals may be easily applied in various ways.

While the foregoing has described what are considered to be the best mode and/or other examples, it is understood that various modifications may be made therein and that the subject matter disclosed herein may be implemented in various forms and examples, and that the teachings may be applied in numerous applications, only some of which have been described herein. It is intended by the following claims to claim any and all applications, modifications and variations that fall within the true scope of the present teachings.

## Claims

1. An ultrasonic probe comprising:
a piezoelectric material; and
a matching layer disposed on a front surface of the piezoelectric material,
wherein electrodes are formed in the matching layer.

2. The ultrasonic probe according to claim 1, wherein external electrodes are formed on front and rear surfaces of the matching layer.

3. The ultrasonic probe according to claim 2, wherein internal electrodes of the matching layer are formed to electrically connect the external electrodes.

4. The ultrasonic probe according to claim 3, wherein the internal electrodes of the matching layer are formed to be perpendicular to the external electrodes.

5. The ultrasonic probe according to claim 1, wherein internal electrodes are formed in a one-dimensional or two-dimensional array.

6. The ultrasonic probe according to claim 1, wherein:
the piezoelectric material and the matching layer are processed into a one-dimensional and two-dimensional array, and
an interval between internal electrodes of the matching layer is smaller than a pitch of an element constituting an array of the piezoelectric material.

7. The ultrasonic probe according to claim 1, wherein the matching layer comprises one or more layers.

8. A method of manufacturing an ultrasonic probe, the method comprising steps of:
forming electrodes in a matching layer; and
installing the matching layer provided with the electrodes on one surface of a piezoelectric material.

9. The method according to claim 8, wherein the step of forming of the electrodes in the matching layer further comprises:
forming a plurality of kerfs at one surface of the matching layer;
forming an electrode on the one surface of the matching layer, at which the kerfs are formed;
filling the kerfs; and
cutting front and rear surfaces of the matching layer to expose the electrodes.

10. The method according to claim 9, wherein the step of forming of the kerfs at the one surface of the matching layer comprises:
forming a plurality of kerfs at the one surface of the matching layer in a one-dimensional or two-dimensional array,
wherein the kerfs have a width smaller than a pitch of an element of the piezoelectric material.

11. The method according to claim 9, wherein the step of forming of an electrode on the one surface of the matching layer, at which the kerfs are formed, comprises:
forming an electrode on at least inner side surfaces of the kerfs,
wherein the step of filling of the kerfs comprises:
filling the kerfs with a material used to form the matching layer,
wherein the step of cutting of the front and rear surfaces of the matching layer to expose the electrodes comprises:
cutting the front and rear surfaces of the matching layer in the transverse direction to expose the electrodes formed on inner side surfaces of the kerfs through the front and rear surfaces of the matching layer,
further comprising the step of:
forming external electrodes on the front and rear surfaces of the matching layer through which the electrodes are exposed after cutting of the front and rear surfaces of the matching layer to expose the electrodes.

12. The method according to claim 8, wherein the step of installing of the matching layer provided with the electrodes on one surface of a piezoelectric material comprises:
installing the matching layer on one surface of the piezoelectric material such that the electrodes formed on the matching layer are electrically connected to the piezoelectric material.

13. The method according to claim 8, further comprising the step of:
processing the matching layer and the piezoelectric material in a one-dimensional or two-dimensional array; and
installing a protective layer on the front surface of the matching layer, after installing of the matching layer on one surface of the piezoelectric material.

14. The method according to claim 13, wherein:
the matching layer comprises internal electrodes formed in a two-dimensional array, and
the step of processing the matching layer and the piezoelectric material in a two-dimensional array is performed by dividing the matching layer and the piezoelectric material in diagonal directions of lattices formed by the internal electrodes processed in the two-dimensional array.

15. The method according to claim 13, wherein the protective layer is grounded, or an electrical signal is applied to the protective layer,
wherein the protective layer comprises an RF shield and/or CS film.
